# EUROPÄISCHE PATENTSCHRIFT

(11) **EP 0 896 735 B1**
(45) Veröffentlichungstag und Bekanntmachung des Hinweises auf die Patenterteilung: **26.07.2000**
(21) Anmeldenummer: 97924861.4
(22) Anmeldetag: 09.04.1997
(51) Int. Cl.: H01L 27/112, H01L 21/8246

(54) **SPEICHERZELLENANORDNUNG, BEI DER VERTIKALE MOS-TRANSISTOREN JE NACH GESPEICHERTER INFORMATION MINDESTENS DREI UNTERSCHIEDLICHE EINSATZSPANNUNGSWERTE AUFWEISEN, UND VERFAHREN ZU DEREN HERSTELLUNG**
STORAGE CELL ARRANGEMENT IN WHICH VERTICAL MOS TRANSISTORS HAVE AT LEAST THREE DIFFERENT THRESHOLD VOLTAGES DEPENDING ON STORED DATA, AND METHOD OF PRODUCING SAID ARRANGEMENT
CONFIGURATION DE CELLULES DE MEMOIRE DANS LAQUELLE DES TRANSISTORS MOS VERTICAUX PRESENTENT AU MOINS TROIS DIFFERENTES VALEURS DE TENSION DE SEUIL EN FONCTION DE L'INFORMATION MEMORISEE, ET PROCEDE PERMETTANT DE LA REALISER

(30) Priorität: 02.05.1996 DE 19617646
(43) Veröffentlichungstag der Anmeldung: 17.02.1999
(73) Patentinhaber: SIEMENS AKTIENGESELLSCHAFT, 80333 München (DE)
(72) Erfinder: HOFMANN, Franz, D-80995 München (DE); KRAUTSCHNEIDER, Wolfgang, D-83104 Hohenthann (DE); WILLER, Josef, D-85521 Riemerling (DE)
(86) Internationale Anmeldenummer: DE9700720
(87) Internationale Veröffentlichungsnummer: WO9742660

(56) Entgegenhaltungen:
- WO-A-96/10266
- US-A- 5 300 804
- US-A- 5 386 381
- US-A- 5 453 637
- PATENT ABSTRACTS OF JAPAN vol. 016, no. 579 (E-1299), 18.Dezember 1992 & JP 04 226071 A (RICOH CO LTD), 14.August 1992,

## Beschreibung

Zur Abspeicherung großer Datenmengen, zum Beispiel für DV-Anwendungen oder zur digitalen Abspeicherung von Musik oder Bildern, werden derzeit hauptsächlich Speichersysteme mit mechanisch bewegten Teilen wie zum Beispiel Festplattenspeicher, Floppy-Discs oder Kompaktdiscs verwendet. Die bewegten Teile sind mechanischem Verschleiß unterworfen. Ferner benötigen sie vergleichsweise viel Volumen und erlauben nur einen langsamen Datenzugriff. Da sie darüber hinaus erschütterungs- und lageempfindlich sind und einen vergleichsweise hohen Energieverbrauch zu ihrem Betrieb haben, sind diese Speichersysteme in mobilen Systemen nur begrenzt einsetzbar.

Zur Speicherung kleinerer Datenmengen sind Festwertspeicher auf Halbleiterbasis bekannt. Vielfach werden diese als planare integrierte Siliziumschaltung realisiert, in der als Speicherzellen MOS-Transistoren verwendet werden. Die Transistoren werden über die Gateelektrode, die mit der Wortleitung verbunden ist, ausgewählt. Der Eingang des MOS-Transistors ist mit einer Referenzleitung verbunden, der Ausgang mit einer Bitleitung. Beim Lesevorgang wird bewertet, ob ein Strom durch den Transistor fließt oder nicht. Entsprechend werden die logischen Werte Null und Eins zugeordnet. Technisch wird die Speicherung von Null und Eins dadurch bewirkt, daß in Speicherzellen, in denen der dem Zustand "kein Stromfluß durch den Transistor" zugeordnete logische Wert gespeichert ist, kein MOS-Transistor hergestellt wird oder keine leitende Verbindung zur Bitleitung realisiert wird. Alternativ können für die beiden logischen Werte MOS-Transistoren realisiert werden, die durch unterschiedliche Dotierstoffkonzentrationen im Kanalgebiet unterschiedliche Einsatzspannungen aufweisen.

Diese Speicher auf Halbleiterbasis erlauben einen wahlfreien Zugriff auf die gespeicherte Information. Die zum Lesen der Information erforderliche elektrische Leistung ist deutlich kleiner als bei den erwähnten Speichersystemen mit mechanisch bewegten Teilen. Da keine bewegten Teile erforderlich sind, entfällt hier auch der mechanische Verschleiß und die Empfindlichkeit gegenüber Erschütterungen. Speicher auf Halbleiterbasis sind daher auch für mobile Systeme einsetzbar.

Die beschriebenen Siliziumspeicher weisen meist einen planaren Aufbau auf. Damit wird pro Speicherzelle ein minimaler Flächenbedarf erforderlich, der im günstigsten Fall bei 4 F² liegt, wobei F die in der jeweiligen Technologie kleinste herstellbare Strukturgröße ist.

Aus DE 42 14 923 A1 oder US-A- 5 300 804 ist eine Festwertspeicherzellenanordnung bekannt, deren Speicherzellen MOS-Transistoren umfassen. Diese MOS-Transistoren sind entlang von Gräben so angeordnet, daß ein Sourcegebiet an den Boden des Grabens angrenzt, ein Draingebiet an die Oberfläche des Substrats angrenzt und ein Kanalgebiet sowohl vertikal zur Oberfläche des Substrats als auch parallel zur Oberfläche des Substrats an Flanke und Boden des Grabens angrenzt. Die Oberfläche des Kanalgebietes ist mit einem Gatedielektrikum versehen. Die Gateelektrode ist als Flankenbedeckung (Spacer) ausgebildet. Die logischen Werte Null und Eins werden durch unterschiedliche Einsatzspannungen, die durch Kanalimplantation bewirkt werden, unterschieden. Bei der Kanalimplantation treffen die implantierenden Ionen unter einem solchen Winkel auf die Oberfläche des jeweiligen Grabens, das durch Abschattungseffekte der gegenüberliegenden Flanke gezielt nur entlang einer Flanke implantiert wird. Die Wortleitungen verlaufen in dieser Speicherzellenanordnung als Spacer entlang den Flanken der Gräben.

Aus JP-OS 4-226071 ist eine weitere Speicherzellenanordnung bekannt, die als Speicherzellen an den Flanken von Gräben angeordnete vertikale MOS-Transistoren umfaßt. Dabei verlaufen am Boden von Gräben und zwischen benachbarten Gräben Diffusionsgebiete, die jeweils die Source/Drain-Gebiete der vertikalen MOS-Transistoren bilden. Die Wortleitungen, die die Gateelektroden der vertikalen MOS-Transistoren umfassen, verlaufen senkrecht zu den Gräben. Die Einsatzspannung der vertikalen MOS-Transistoren wird durch eine gewinkelte Implantation eingestellt.

Aus US-PS 4 663 644 ist eine Speicherzellenanordnung bekannt, die als Speicherzellen vertikale MOS-Transistoren umfaßt. Diese vertikalen MOS-Transistoren sind jeweils an den Flanken von Gräben angeordnet. Die Wortleitungen, die jeweils die Gateelektroden der vertikalen MOS-Transistoren umfassen, sind in den Gräben angeordnet. In jedem Graben sind zwei Wortleitungen angeordnet. Die Bitleitungen sind als Leiterbahnen auf der Oberfläche des Substrats realisiert. Der Kontakt zwischen den Bitleitungen und den jeweiligen Source/Drain-Gebieten, die an die Oberfläche des Substrats angrenzen, ist über ein Kontaktloch realisiert. Die Source/Drain-Gebiete, die an den Boden der Gräben angrenzen, sind als durchgehende dotierte Schicht realisiert und werden auf Referenzpotential gelegt. In dieser Speicherzellenanordnung wird die Information in Form unterschiedlich hoher Einsatzspannungen der MOS-Transistoren gespeichert. Die unterschiedlichen Einsatzspannungen werden durch unterschiedliche Dotierstoffkonzentrationen im Kanalgebiet der MOS-Transistoren realisiert. Zur Bildung einer erhöhten Dotierstoffkonzentration im Kanalgebiet wird eine dotierte Schicht abgeschieden und so strukturiert, daß Flanken, in denen erhöhte Dotierstoffkonzentrationen gebildet werden sollen, von der strukturierten Dotierstoffschicht bedeckt bleiben. Durch Ausdiffusion aus der strukturierten Dotierstoffschicht werden die Kanalbereiche mit erhöhter Dotierstoffkonzentration gebildet.

Aus WO-A-96/10266 ist eine Speicherzellenanordnung bekannt, die als Speicherzellen Vertikale MOS-Transistoren umfaßt. Die unterschiedlichen Einsatzspannungen werden durch unterschiedlich dicke Gatedielektrika realisiert.

Zur Erhöhung der effektiven Speicherdichte ist ferner vorgeschlagen worden( siehe zum Beispiel Yasushi Kubota, Shinji Toyoyama, Yoji Kanie, Shuhei Tsuchimoto "Proposal of New Multiple-Valued Mask-ROM Design" IEICE Trans. Electron Vol. E77, p. 601, April 1994), eine Halbleiterspeicheranordnung mit planaren MOS-Transistoren im Sinne einer Mehrwertlogik zu programmieren. Dieses Vorgehen wird auch als Multi-Level-Programmierung bezeichnet. Dabei werden die MOS-Transistoren so hergestellt, daß sie, je nach eingespeicherter Information vier unterschiedliche Einsatzspannungswerte aufweisen. Jedem der Einsatzspannungswerte werden dann zwei logische Werte, das heißt, "0" und "0",
"0" und "1", "1" und "0" oder "1" und "1" zugeordnet. Auf diese Weise steigt die effektive Speicherdichte um einen Faktor zwei, da in jeder Speicherzelle zwei logische Werte gespeichert werden, ohne daß sich dadurch die Fläche der Speicherzelle verändert. Die unterschiedlichen Einsatzspannungswerte werden durch unterschiedliche Kanaldotierungen realisiert. Für jeden Einsatzspannungswert wird eine maskierte Implantation durchgeführt. Für die Multi-Level-Programmierung sind daher vier zusätzliche Masken erforderlich.

Aus US-A- 5 386 381 ist eine Speicherzellenanordnung bekannt, bei der planare MOS-Transistoren je nach gespeicherter Information mindestens drei unterschiedliche Einsatzspannungswerte aufweisen, die durch unterschiedliche Kanaldotierungen realisiert werden.

Der Erfindung liegt das Problem zugrunde, eine Speicherzellenanordnung auf Halbleiterbasis anzugeben, bei der eine erhöhte Speicherdichte erzielt wird und die mit wenigen Herstellungsschritten und hoher Ausbeute herstellbar ist. Desweiteren soll ein Verfahren zur Herstellung einer solchen Speicherzellenanordnung angegeben werden.

Dieses Problem wird erfindungsgemäß gelöst durch eine Speicherzellenanordnung nach Anspruch 1 sowie ein Verfahren zu deren Herstellung nach Anspruch 4. Weitere Ausgestaltungen der Erfindung ergeben sich aus den Unteransprüchen.

In der erfindungsgemäßen Speicherzellenanordnung sind in einem Substrat Speicherzellen vorgesehen, die jeweils einen zur Hauptfläche vertikalen MOS-Transistor umfassen. Als Substrat wird vorzugsweise ein Substrat aus monokristallinem Silizium oder die Siliziumschicht eines SOI-Substrats verwendet. Die vertikalen MOS-Transistoren weisen je nach gespeicherter Information mindestens drei unterschiedliche Einsatzspannungswerte auf. Die Speicherzellenanordnung wird im Sinne einer Mehrwertlogik programmiert.

Einer der unterschiedlichen Einsatzspannungswerte wird dadurch realisiert, daß die entsprechenden MOS-Transistoren ein Gatedielektrikum mit einer anderen Dicke als die anderen MOS-Transistoren aufweist. Vorzugsweise ist die Dicke des Gatedielektrikums größer als bei den anderen MOS-Transistoren, so daß ein Dickoxidtransistor gebildet wird. Die übrigen Einsatzspannungswerte werden durch unterschiedliche Kanaldotierungen realisiert.

Vorzugsweise sind 2ⁿ Einsatzspannungen mit n > 1 realisiert, da in jeder Speicherzelle dann n logische Werte gespeichert sind.

Vorzugsweise sind in dem Substrat streifenförmige, im wesentlichen parallel verlaufende Gräben vorgesehen. Am Boden der Gräben und an der Hauptfläche zwischen benachbarten Gräben sind streifenförmige dotierte Gebiete angeordnet, die von einem zweiten, dem ersten entgegengesetzten Leitfähigkeitstyp dotiert sind. An den Flanken der Gräben sind jeweils Gatedielektrika angeordnet. Es sind Wortleitungen vorgesehen, die quer zu den Gräben verlaufen und die im Bereich der Flanken der Gräben Gateelektroden für die vertikalen MOS-Transistoren umfassen. Die vertikalen MOS-Transistoren werden jeweils aus zwei an dieselbe Flanke eines der Gräben angrenzenden streifenförmigen dotierten Gebiete, die als Source/Drain-Gebiet wirken, die dazwischen angeordnete Flanke des Grabens mit dem Gatedielektrikum und den darüber angeordneten Teil einer der Wortleitungen gebildet. Die streifenförmigen dotierten Gebiete werden im Betrieb der Speicherzellenanordnung als Bit-bzw. Referenzleitung verwendet.

Vorzugsweise wird der Abstand zwischen benachbarten Gräben so gewählt, daß er im wesentlichen gleich der Breite der Gräben ist. Der Abstand zwischen benachbarten Wortleitungen wird ebenfalls gleich der Breite der Wortleitungen gewählt. Wird die Breite der Gräben und die Breite der Wortleitungen entsprechend der minimalen Strukturbreite F in der jeweiligen Technologie gewählt, so ergibt sich für die Speicherzelle ein Platzbedarf von 2 F². Weisen die MOS-Transistoren vier unterschiedliche Einsatzspannungswerte auf, so sind in jeder Speicherzelle zwei logische Werte, das heißt zwei Bit gespeichert. Der Platzbedarf pro Bit beträgt dann F². Legt man eine minimale Strukturbreite von F = 0,4 µm zugrunde und weisen die MOS-Transistoren vier unterschiedliche Einsatzspannungswerte auf, so wird in der Speicherzellenanordnung eine Speicherdichte von etwa 6,2 Bit/µm² erzielt.

Zur Herstellung der erfindungsgemäßen Speicherzellenanordnung werden vorzugsweise in einer Hauptfläche eines Substrats streifenförmige Gräben gebildet, die im wesentlichen parallel verlaufen. An den Flanken der Gräben zur Hauptfläche werden vertikale MOS-Transistoren gebildet, die als Speicherzellen wirken und die je nach eingespeicherter Information mindestens drei unterschiedliche Einsatzspannungswerte aufweisen.

Vorzugsweise werden am Boden der Gräben und an der Hauptfläche zwischen benachbarten Gräben streifenförmige dotierte Gebiete gebildet, die von einem zweiten, zum ersten entgegengesetzten Leitfähigkeitstyp dotiert sind. Anschließend wird eine isolierende Schicht aufgebracht. Auf der isolierenden Schicht wird eine erste Maske, zum Beispiel aus Photolack, erzeugt, die erste Öffnungen aufweist. Die isolierende Schicht wird unter Verwendung der ersten Maske so strukturiert, daß im Bereich der ersten Öffnungen die Flanken der Gräben mindestens teilweise freigelegt werden. Die freigelegten Flanken werden dotiert.

Auf der isolierenden Schicht wird eine zweite Maske, zum Beispiel aus Photolack, erzeugt, die zweite Öffnungen aufweist. Die isolierende Schicht wird unter Verwendung der zweiten Maske so strukturiert, daß im Bereich der zweiten Öffnungen die Flanken der Gräben mindestens teilweise freigelegt werden.

Außerhalb der ersten und zweiten Öffnungen bleiben die Flanken von der strukturierten isolierenden Schicht bedeckt. Die strukturierte isolierende Schicht wirkt in diesem Bereich als dickes Gatedielektrikum. Im Bereich der ersten und zweiten Öffnungen wird an den Flanken ein Gatedielektrikum gebildet.

Anschließend werden Wortleitungen gebildet, die quer zu den Gräben verlaufen.

Im Bereich der ersten Öffnungen wird der Einsatzspannungswert durch die Dotierung der freigelegten Flanken, im Bereich der zweiten Öffnungen durch die Dotierung des Substrats und außerhalb der ersten und zweiten Öffnungen durch die Dicke der isolierenden Schicht eingestellt.

Zur Herstellung von mehr als drei Einsatzspannungswerten werden vor der Bildung der zweiten Maske weitere Masken gebildet, Strukturierungen der isolierenden Schicht durchgeführt und freigelegte Flanken dotiert.

Da einer der Einsatzspannungswerte über die dicke der strukturierten, isolierenden Schicht eingestellt wird, ist die Zahl der für die Programmierung erforderlichen Masken um eins geringer als die Zahl der Einsatzspannungswerte.

Die Dotierung der freigelegten Flanken erfolgt vorzugsweise durch eine gewinkelte Implantation. Die Implantation erfolgt vorzugsweise mit einem Neigungswinkel im Bereich zwischen 20° und 30° gegen die Normale der Hauptfläche. Derartige Neigungswinkel sind in vielen Implantationsanlagen zur Vermeidung des Channeling-Effekts standardmäßig vorgesehen.

Alternativ werden die freigelegten Flanken durch Ausdiffusion aus einer dotierten Schicht dotiert. Die dotierte Schicht wird ganzflächig oberhalb der strukturierten isolierenden Schicht aufgebracht. Die dotierte Schicht wird vorzugsweise aus dotiertem Glas, dotiertem Polysilizium oder dotiertem amorphem Silizium gebildet. Die Verwendung von dotiertem Glas hat den Vorteil, daß die dotierte Schicht in diesem Fall selektiv zum Substrat entfernt werden kann.

Die isolierende Schicht wird vorzugsweise in einer solchen Schichtdicke aufgebracht, daß sie die Gräben auffüllt. Vor der Bildung der ersten Maske wird die Oberfläche des Substrats freigelegt. bei der Strukturierung der isolierenden Schicht werden die jeweiligen Flanken der Gräben im wesentlichen vollständig freigelegt. Durch das Auffüllen der Gräben wird eine planare Struktur erzielt. Dadurch werden bei der Bildung der Masken zur Strukturierung der isolierenden Schicht Fokusprobleme vermieden. Ferner wird die Streuung der einzelnen Einsatzspannungswerte reduziert.

Die Gräben werden vorzugsweise durch anisotropes Ätzen unter Verwendung einer Grabenmaske gebildet.

Die streifenförmigen dotierten Gebiete am Boden der Gräben und an der Hauptfläche zwischen benachbarten Gräben werden vorzugsweise durch eine Implantation nach der Grabenbildung und nach Entfernen der Grabenmaske erzeugt. Dabei ist es vorteilhaft, die Flanken der Gräben vor der Implantation mit Spacern zu versehen, die bei der Implantation maskierend wirken. Diese Spacer werden anschließend entfernt. Die Bildung der Gräben und der streifenförmigen dotierten Gebiete erfordert nur eine Maske.

Alternativ können die streifenförmigen dotierten Gebiete dadurch hergestellt werden, daß vor der Bildung der Gräben ein dotierter Bereich an der Hauptfläche erzeugt wird, der das gesamte Speicherzellenfeld überdeckt. Bei der Öffnung der Gräben wird dieser dotierte Bereich in die streifenförmigen dotierten Gebiete an der Hauptfläche unterteilt. Die streifenförmigen dotierten Gebiete am Boden der Gräben werden nach der Öffnung der Gräben durch Ionenimplantation erzeugt. Bei Verwendung einer Grabenmaske ist es dabei vorteilhaft, diese bei der Implantation als Maske auf der Hauptfläche zu belassen.

Die Strukturierung der isolierende Schicht erfolgt vorzugsweise durch anisotropes Ätzen. Die Strukturierung der isolierenden Schicht kann jedoch auch durch kombiniertes isotropes und anisotropes Ätzen erfolgen. Das Ätzen erfolgt selektiv zu dem Substrat.

Im folgenden wird die Erfindung anhand eines Ausführungsbeispiels und der Figuren näher erläutert.
- Figur 1: zeigt ein Substrat mit einer von einem ersten Leitfähigkeitstyp dotierten Wanne.
- Figur 2: zeigt das Substrat nach der Ätzung von streifenförmigen Gräben.
- Figur 3: zeigt das Substrat nach der Bildung streifenförmiger dotierter Gebiete an den Böden der Gräben und zwischen benachbarten Gräben an der Hauptfläche.
- Figur 4: zeigt das Substrat nach dem Aufbringen einer isolierenden Schicht.
- Figur 5: zeigt das Substrat nach dem Freilegen der Hauptfläche und der Bildung einer ersten Maske.
- Figur 6: zeigt das Substrat nach der ersten Strukturierung der isolierende Schicht.
- Figur 7: zeigt das Substrat nach der Bildung einer zweiten Maske.
- Figur 8: zeigt das Substrat nach der zweiten Strukturierung der isolierenden Schicht.
- Figur 9: zeigt das Substrat nach der Bildung einer dritten Maske.
- Figur 10: zeigt das Substrat nach der dritten Strukturierung der isolierenden Schicht.
- Figur 11: zeigt das Substrat nach Bildung von einem Gatedielektrikum und quer zu den Gräben verlaufenden Wortleitungen.
- Figur 12: zeigt eine Aufsicht auf das Substrat nach Bildung der Wortleitungen.

Die Darstellungen in den Figuren sind nicht maßstäblich.

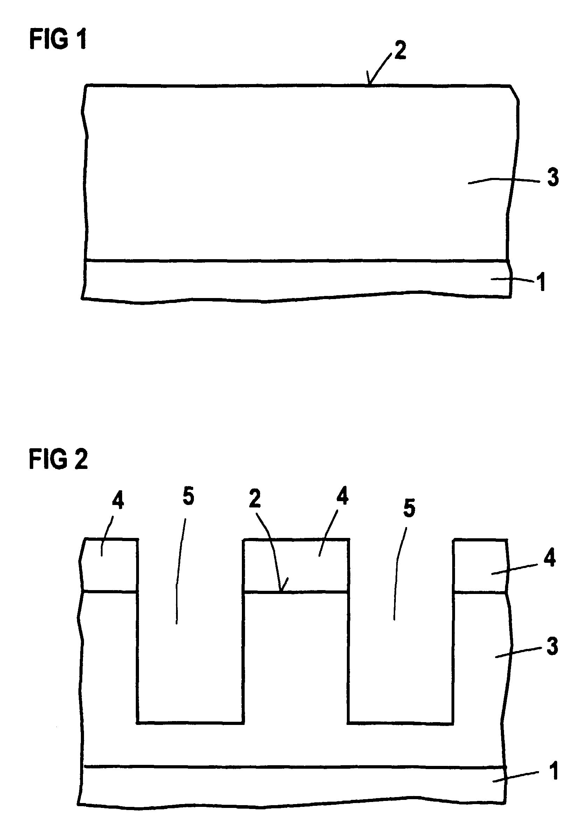

In einem Substrat 1 aus zum Beispiel p-dotiertem monokristallinem Silizium mit einer Dotierstoffkonzentration von 5 x 10¹⁵ cm⁻³ wird in einer Hauptfläche 2 durch Implantation und anschließendes Tempern eine p-dotierte Wanne 3 mit einer Dotierstoffkonzentration von 2 x 10¹⁷ cm⁻³ erzeugt (siehe Figur 1). Bei der Implantation der p-dotierten Wanne 3 wird ein Streuoxid in einer Dicke von zum Beispiel 50 nm (nicht dargestellt) verwendet, das nach dem Eintreiben der p-dotierten Wanne 3 mit 180 keV, 7 x 10¹² cm⁻² wieder entfernt wird. Die p-dotierte Wanne 3 erstreckt sich mindestens über einen Bereich für ein Zellenfeld.

Auf der Hauptfläche 2 wird eine SiO₂-Schicht in einer Schichtdicke von zum Beispiel 300 nm zum Beispiel in einem TEOS-Verfahren abgeschieden. Mit Hilfe photolithographischer Prozeßschritte wird die SiO₂-Schicht strukturiert, wobei eine Grabenmaske 4 gebildet wird. Die Grabenmaske 4 weist streifenförmige Öffnungen auf, die im wesentlichen parallel verlaufen. Die streifenförmigen Öffnungen in der Grabenmaske 4 weisen eine Breite von zum Beispiel 0,4 µm, eine Länge von zum Beispiel 125 µm und einen Abstand von 0,4 µm auf.

Unter Verwendung der Grabenmaske 4 als Ätzmaske werden in einem anisotropen Atzprozeß zum Beispiel mit HBr, He, O₂, NF₃ in die Hauptfläche 2 des Substrats 1 Gräben 5 geätzt. Die Gräben 5 weisen entsprechend den Öffnungen der Grabenmaske 4 parallel zur Hauptfläche 2 einen streifenförmigen Querschnitt auf. Sie weisen eine Weite von zum Beispiel 0,4 µm, eine Länge von zum Beispiel 125 um und einen Abstand von zum Beispiel 0,4 µm auf. Die Tiefe der Gräben beträgt zum Beispiel 0,6 µm (siehe Figur 2). Es werden zum Beispiel 32 parallele Gräben 5 gebildet.

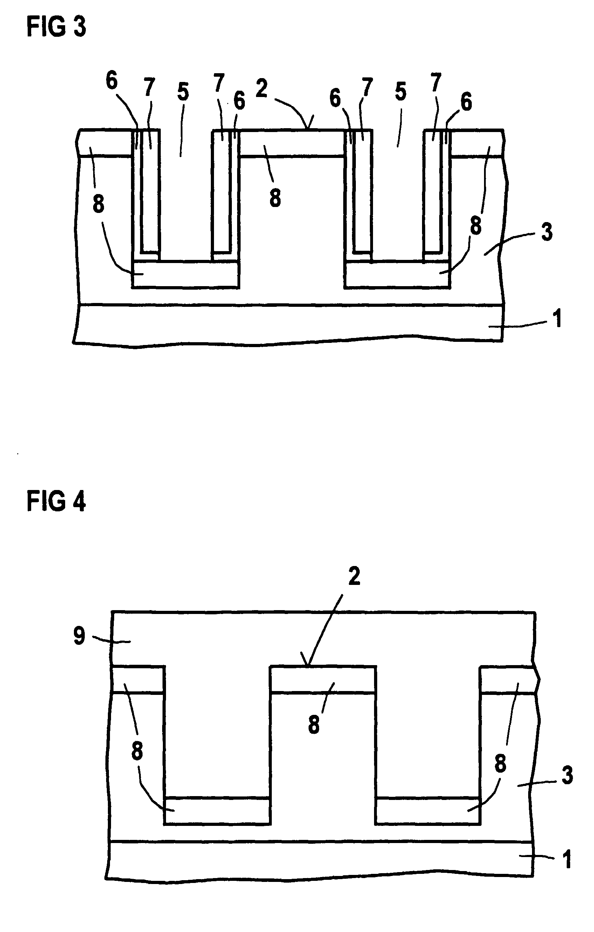

Anschließend wird die Grabenmaske 4 zum Beispiel durch einen HF-Dip abgelöst. Um die Qualität der Kristalloberflächen zu verbessern, wird durch thermische Oxidation eine SiO₂-Schicht 6 (sogenanntes sacrificial oxide) in einer Dicke von zum Beispiel 20 nm erzeugt (siehe Figur 3). Durch konforme Abscheidung zum Beispiel in einem TEOS-Verfahren einer SiO₂-Schicht in einer Schichtdicke von zum Beispiel 60 nm und anschließendes anisotropes Trockenätzen mit CHF₃, O₂ werden an senkrechten Flanken der Gräben 5 SiO₂-Spacer 7 erzeugt (siehe Figur 3). Anschließend wird ein dünnes Streuoxid in einem TEOS-Verfahren abgeschieden (nicht dargestellt). Durch Implantation senkrecht zur Hauptfläche 2 mit As mit einer Dosis von 5 x 10¹⁵ cm⁻² und einer Energie von 80 keV und einen anschließenden Temperschritt zur Dotierstoffaktivierung werden am Boden der Gräben 5 und an der Hauptfläche 2 zwischen benachbarten Gräben 5 n⁺-dotierte, streifenförmige Gebiete 8 gebildet. In den streifenförmigen, dotierten Gebieten 8 wird eine Dotierstoffkonzentration von zum Beispiel 10²¹ cm⁻³ eingestellt. Bei der Implantation wirkt die dünne TEOS-Schicht als Streuoxid (nicht dargestellt).

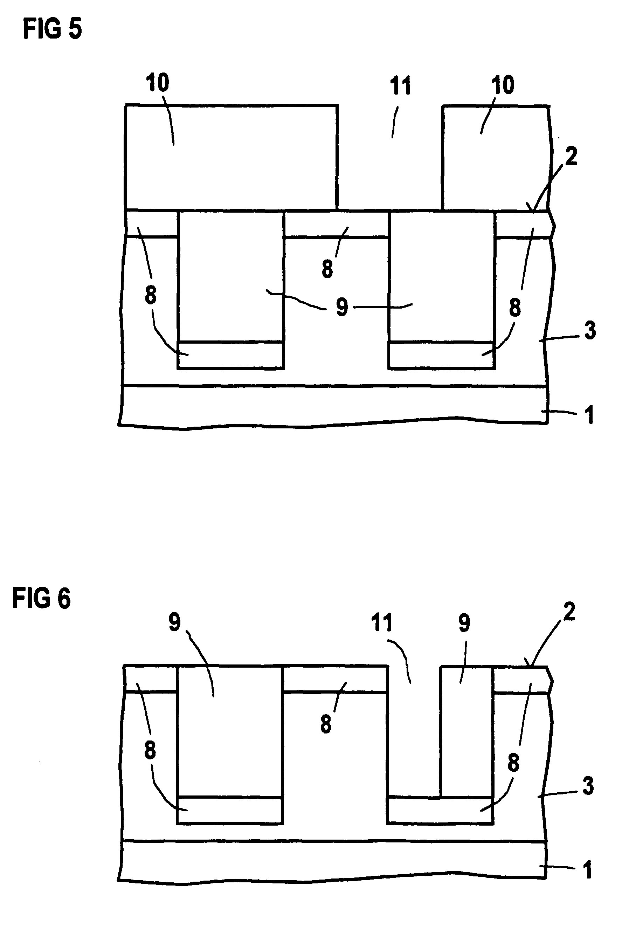

Anschließend werden die SiO₂-Spacer 7 und die SiO₂-Schicht 6 zum Beispiel durch naßchemisches Ätzen in einem HF-Dip entfernt. Es wird eine isolierende Schicht 9 zum Beispiel in einem TEOS-Verfahren aus SiO₂ abgeschieden. Die isolierende Schicht 9 wird in einer Schichtdicke von 600 nm abgeschieden (siehe Figur 4). Diese Schicht wird in einem Trockenätzverfahren mit zum Beispiel HBr, Cl₂, He zurückgeätzt. Die isolierende Schicht 9 füllt die Gräben 5 vollständig auf (siehe Figur 5).

Anschließend wird eine erste Maske 10 zum Beispiel aus Photolack unter Verwendung photolithographischer Prozeßschritte gebildet. Die erste Maske 10 weist im Zellenfeld erste Öffnungen 11 auf. Der Bereich außerhalb des Zellenfeldes, in dem zum Beispiel eine Peripherie für die Speicherzellenanordnung gebildet wird, wird von der ersten Maske 10 abgedeckt. Die ersten Öffnungen 11 werden so justiert, daß sie jeweils mindestens eine Flanke der Gräben 5 überlappen. Die Abmessungen der ersten Öffnungen 11 parallel zur Hauptfläche 2 entsprechen jeweils der Weite der Gräben 5. Größere Abmessungen der ersten Öffnungen 11 kommen durch das Zusammenfallen benachbarter Öffnungen zustande. Die erste Maske 10 wird so justiert, daß die ersten Öffnungen 11 jeweils überlappend zu den Flanken der Gräben 5 angeordnet sind. Werden die Gräben 5 mit einer Weite entsprechend der in der jeweiligen Technologie minimal herstellbaren Strukturgröße F von zum Beispiel 0,4 µm gebildet, so weisen die ersten Öffnungen 11 ebenfalls minimale Abmessungen von F x F auf. Bei der Justierung der ersten Maske 10 wird in diesem Fall ausgenutzt, daß die Justiergenauigkeit jeweils größer ist als die in der jeweiligen Technologie kleinste herstellbare Strukturgröße F. In einer 0,4 um-Technologie beträgt die Justiergenauigkeit beispielsweise F/3.

In einem anisotropen Ätzverfahren zum Beispiel mit HBr, Cl₂, He wird die isolierende Schicht 9 strukturiert. Die erste Maske 10 wirkt dabei als Atzmaske. Dabei werden im Bereich der ersten Öffnungen 11 die Flanken der Gräben 5 und die Siliziumoberfläche an den Böden der Gräben 5 und an der Hauptfläche 2 zwischen benachbarten Gräben 5 freigelegt. Unter der ersten Maske 10 wird die isolierende Schicht 9 dagegen nicht angegriffen.

Nach der Strukturierung der isolierende Schicht 9 wird die Maske 10 entfernt (siehe Figur 6).Anschließend wird ein dünnes Streuoxid (ca. 10 nm) mit einem TEOS-Verfahren abgeschieden (nicht dargestellt).

Anschließend werden in einem ersten Implantationsschritt zwei gewinkelte Implantationen mit Bor mit einer Dosis von beispielsweise 7 · 10¹² cm⁻² und einer Energie von beispielsweise 30 keV durchgeführt. Dabei beträgt der Neigungswinkel gegen die Normale der Hauptfläche 2 20° bis 30°, und - 20° bis - 30°. Dabei werden die freiliegenden Flanken der Gräben 5 dotiert. In den freiliegenden Flanken wird eine Dotierstoffkonzentration von beispielsweise 3 · 10¹⁷ cm⁻³, eingestellt. Da die Dotierung in den streifenförmigen dotierten Gebieten 8 10²¹ cm⁻³ beträgt, kann die Implantation von Bor in diesem Bereich toleriert werden.

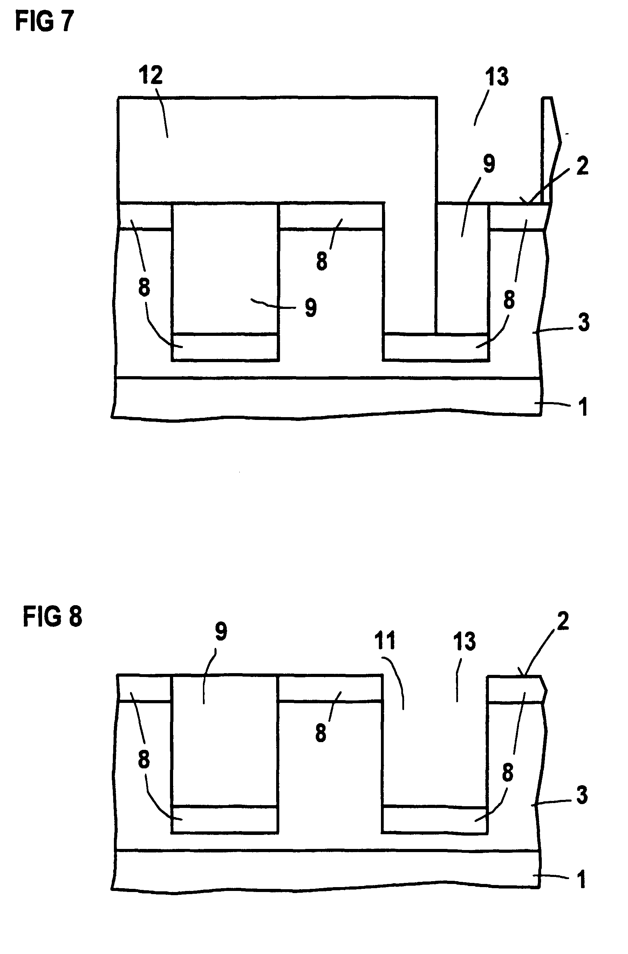

Anschließend wird eine zweite Maske 12 zum Beispiel aus Photolack unter Verwendung photolithographischer Prozeßschritte gebildet (siehe Figur 7). Die zweite Maske 12 weist im Zellenfeld zweite Öffnungen 13 auf. Der Bereich außerhalb des Zellenfeldes, in dem zum Beispiel eine Peripherie für die Speicherzellenanordnung gebildet wird, wird von der zweiten Maske 12 abgedeckt. Die zweiten Öffnungen 13 werden so justiert, daß sie jeweils mindestens eine Flanke der Gräben 5 überlappen. Die Abmessungen und die Justierung der zweiten Öffnungen 13 entsprechen denjenigen der ersten Öffnungen 11

In einem anisotropen Ätzverfahren zum Beispiel mit HBr, Cl₂, He wird die isolierende Schicht 9 strukturiert. Die zweite Maske 12 wirkt dabei als Ätzmaske. Dabei werden im Bereich der zweiten Öffnungen 13 die Flanken der Gräben 5 und die Siliziumoberfläche an den Böden der Gräben 5 und an der Hauptfläche 2 zwischen benachbarten Gräben 5 freigelegt. Unter der zweiten Maske 12 wird die isolierende Schicht 9 dagegen nicht angegriffen.

Nach der zweiten Strukturierung der isolierenden Schicht 9 wird die zweite Maske 12 entfernt (siehe Figur 8). Anschließend wird ein dünnes Streuoxid (ca. 10 nm) mit einem TEOS-Verfahren abgeschieden (nicht dargestellt).

Anschließend werden in einem zweiten Implantationsschritt zwei gewinkelte Implantationen mit Bor mit einer Dosis von beispielsweise 7 · 10¹² cm⁻² und einer Energie von beispielsweise 30 keV durchgeführt. Dabei beträgt der Neigungswinkel gegen die Normale der Hauptfläche 2 20° bis 30°, und - 20° bis - 30°. Dabei werden die freiliegenden Flanken der Gräben 5 dotiert. In den freiliegenden Flanken im Bereich der zweiten Öffnungen 13 wird eine Dotierstoffkonzentration von beispielsweise 3 · 10¹⁷ cm⁻³, eingestellt. Im Bereich der ersten Öffnungen 11 steigt die Dotierstoffkonzentration durch den zweiten Implantationsschritt auf zum Beispiel 4 · 10¹⁷ cm⁻³. Da die Dotierung in den streifenförmigen dotierten Gebieten 8 10²¹ cm⁻³ beträgt, kann die Implantation von Bor in diesem Bereich toleriert werden.

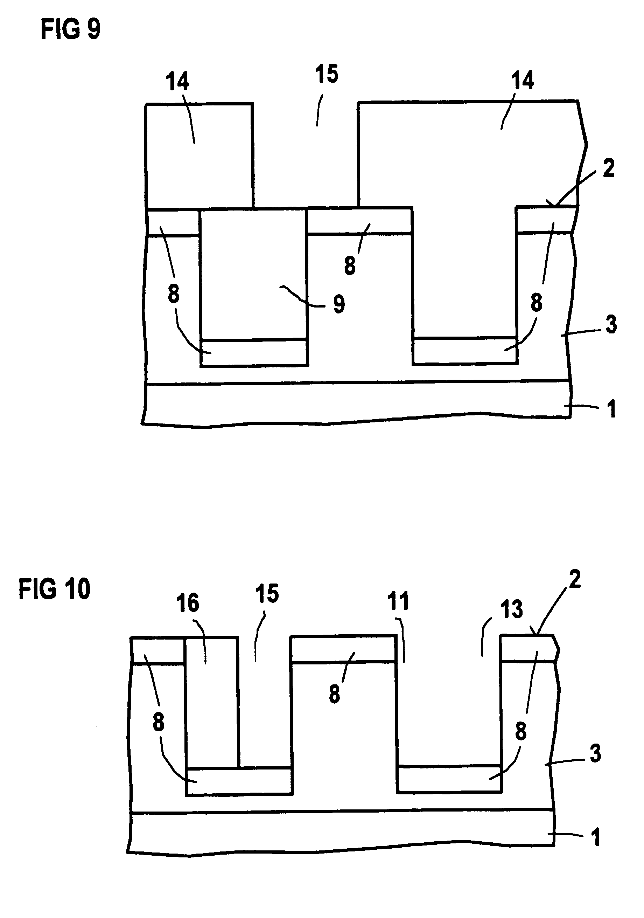

Anschließend wird eine dritte Maske 14 zum Beispiel aus Photolack unter Verwendung photolithographischer Prozeßschritte gebildet (siehe Figur 9). Die dritte Maske 14 weist im Zellenfeld dritte Öffnungen 15 auf. Der Bereich außerhalb des Zellenfeldes, in dem zum Beispiel eine Peripherie für die Speicherzellenanordnung gebildet wird, wird von der dritten Maske 14 abgedeckt. Die dritten Öffnungen 15 werden so justiert, daß sie jeweils mindestens eine Flanke der Gräben 5 überlappen. Die Abmessungen und die Justierung der dritten Öffnungen 15 entsprechen denjenigen der ersten Öffnungen 11 und der zweiten Öffnungen 13.

In einem anisotropen Ätzverfahren zum Beispiel mit HBr, Cl₂, He wird die isolierende Schicht 9 strukturiert. Die dritte Maske 14 wirkt dabei als Ätzmaske. Dabei werden im Bereich der dritten Öffnungen 15 die Flanken der Gräben 5 und die Siliziumoberfläche an den Böden der Gräben 5 und an der Hauptfläche 2 zwischen benachbarten Gräben 5 freigelegt. Unter der dritten Maske 14 wird die isolierende Schicht 9 dagegen nicht angegriffen. Außerhalb der Bereiche der ersten Öffnungen 11, der zweiten Öffnungen 13 und der dritten Öffnungen 15 verbleiben Isolationsstrukturen 16, die senkrecht zu der Flanke, an der sie angeordnet sind, ein Ausdehnung entsprechend der halben Grabenweite aufweisen.

Nach der dritten Strukturierung der isolierenden Schicht 9 wird die dritte Maske 12 entfernt (siehe Figur 10). Im Bereich der dritten Öffnungen 15 verbleibt die Dotierstoffkonzentration in den Flanken der Gräben 5 bei beispielsweise 2 10¹⁷ cm⁻³.

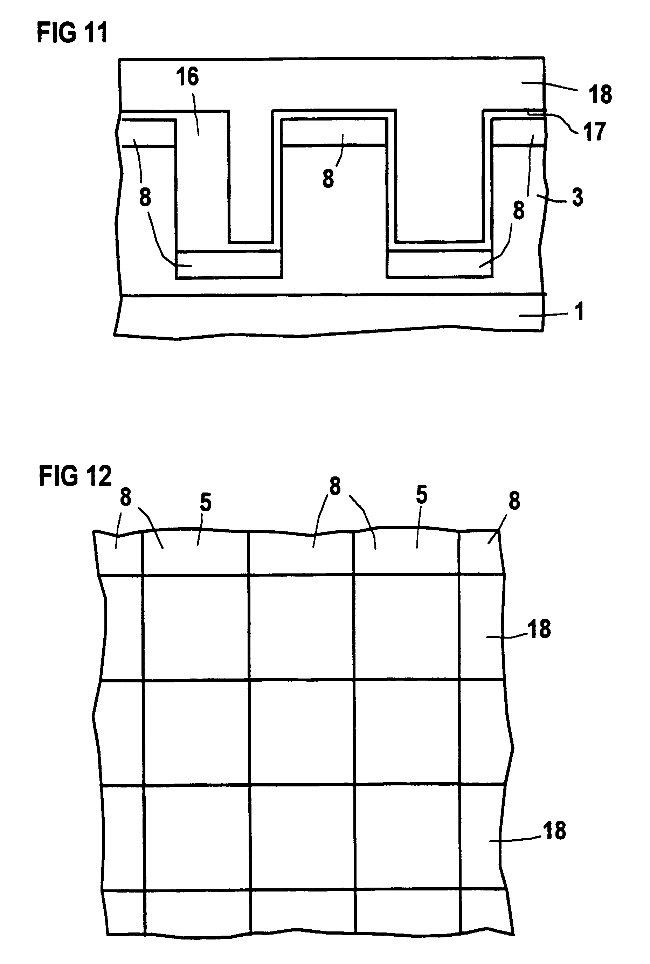

In einem HF-Dip wird nun das dünne TEOS-Streuoxid entfernt. An den freiliegenden Flanken wird ein Gatedielektrikum 17 zum Beispiel durch thermische Oxidation in einer Schichtdicke von zum Beispiel 10 nm erzeugt (siehe Figur 11). Anschließend wird ganzflächig eine n⁺-dotierte Polysiliziumschicht in einer Schichtdicke von 400 nm aufgebracht. Dieses erfolgt vorzugsweise durch in situ dotiertes Abscheiden von Polysilizium. Alternativ wird die Polysiliziumschicht undotiert abgeschieden und anschließend durch Belegung mit einer POCL-Schicht (POCL steht für PCl₃: Phosphor-Chlorid-Gas) dotiert. Mit Hilfe photolithographischer Prozeßschritte wird die dotierte Polysiliziumschicht durch anisotropes Ätzen strukturiert. Dabei entstehen Wortleitungen 18, die quer zu den Gräben 5 verlaufen (siehe Figur 11 und Figur 12). Die Wortleitungen 18 weisen eine Breite von zum Beispiel F = 0,4 µm auf. Der Abstand zwischen benachbarten Wortleitungen 18 beträgt ebenfalls F.

Die vertikalen MOS-Transistoren werden jeweils aus zwei streifenförmigen dotierten Gebieten 8, die an dieselbe Flanke eines der Gräben 5 angrenzen, der dazwischen angeordnete Teil der Wanne 3 als Kanalgebiet, dem Gatedielektrikum 17 beziehungsweise der Isolationsstruktur 16 und dem daran angrenzenden Teil einer der Wortleitungen 18 gebildet.

Die vertikalen MOS-Transistoren weisen vier unterschiedliche Einsatzspannungswerte auf. Ein erster Einsatzspannungswert wird durch die Dicke der Isolationsstruktur 16 bestimmt, die als Gatedielektrikum eines Dickoxidtransistors wirkt. Ein zweiter Einsatzspannungswert wird durch die Dotierstoffkonzentration, die sich durch den ersten und den zweiten Implantationsschritt einstellt, bestimmt. Ein dritter Einsatzspannungswert wird durch die Dotierstoffkonzentration, die sich durch den zweiten Implantationsschritt einstellt, bestimmt. Ein vierter Einsatzspannungswert wird durch die Dotierstoffkonzentration der Wanne 3 bestimmt.

Die Programmierung der Speicherzellenanordnung erfolgt daher bei der Strukturierung der isolierenden Schicht 9. Über die Anordnung der ersten Öffnungen 11, der zweiten Öffnungen 13 und der dritten Öffnungen 15 in den jeweiligen Masken 10, 12, 14 wird die Information in die Speicherzellenanordnung übertragen.

Die Ausdehnung des vertikalen MOS-Transistors parallel zum Verlauf der streifenförmigen Gräben 5 ist durch die Breite der Wortleitungen 18 gegeben. Entlang einer Flanke eines der Gräben benachbarte MOS-Transistoren sind durch den Abstand zwischen benachbarten Wortleitungen 18 voneinander getrennt. Die streifenförmigen dotierten Gebiete 8 verlaufen jeweils über das gesamte Zellenfeld. Sie bilden Leitungen, die je nach Beschaltung als Bitleitung oder Referenzleitung eingesetzt werden und die die Source/Drain-Gebiete von entlang einem Graben benachbarten MOS-Transistoren miteinander verbinden.

Alternativ zu dem ersten und zweiten Implantationsschritt werden die freigelegten Flanken der Gräben 5 durch Ausdiffusion aus einer dotierten Schicht gebildet. Dazu wird nach Entfernen der ersten Maske 10 bzw. zweiten Maske 12 ganzflächig eine dotierte Schicht zum Beispiel aus Borsilikatglas in einer Schichtdicke von 50 nm abgeschieden (nicht dargestellt). In einem Temperschritt bei zum Beispiel 900° werden die Flanken durch Ausdiffusion dotiert. Vor der Bildung der zweiten Maske 12 bzw. der dritten Maske 14 wird die dotierte Schicht jeweils zum Beispiel in einem HF-Dip entfernt.

Zum Auslesen der Speicherzellen werden die streifenförmigen dotierten Gebiete 8 als Bit- bzw. Referenzleitung verwendet. Die zu bewertende Speicherzelle wird über die Wortleitung ausgewählt. Beim Auslesen wird die Einsatzspannung des jeweiligen MOS-Transistors bewertet.

In Figur 12 ist eine Aufsicht auf die Speicherzellenanordnung dargestellt. Es ist der Verlauf der Wortleitungen 15 quer zu den Gräben 5 dargestellt. Ferner sind die streifenförmigen, dotierten Gebiete 8 eingetragen, die am Boden der Gräben 5 sowie zwischen benachbarten Gräben 5 verlaufen.

Jede Speicherzelle umfaßt einen vertikalen MOS-Transistor, der parallel zum Verlauf der streifenförmigen Gräben 5 eine Ausdehnung von 2 F, senkrecht zum Verlauf der streifenförmigen Gräben 5 eine Ausdehnung von F aufweist. Der Platzbedarf pro Speicherzelle beträgt daher 2 F².

Die Herstellung der Speicherzellenanordnung wird abgeschlossen mit der Abscheidung eines Zwischendielektrikums, der Öffnung von Kontaktlöchern und der Herstellung einer Metallisierung (nicht dargestellt).

## Patentansprüche

1. Speicherzellenanordnung
- bei der in einem Substrat (1), das mindestens im Bereich einer Hauptfläche (2) von einem ersten Leitfähigkeitstyp dotiertes Halbleitermaterial umfaßt, Speicherzellen vorgesehen sind, die jeweils einen zur Hauptfläche (2) vertikalen MOS-Transistor umfassen,
- bei der die vertikalen MOS-Transistoren je nach gespeicherter Information mindestens drei unterschiedliche Einsatzspannungswerte aufweisen,
- bei der ein erster Einsatzspannungswert durch die Dicke des Gatedielektrikums (16) und ein zweiter und ein dritter Einsatzspannungswert durch unterschiedliche Kanaldotierungen realisiert werden.

2. Speicherzellenanordnung nach Anspruch 1,
- bei der in dem Substrat (1) streifenförmige, im wesentlichen parallel verlaufende Gräben (5) vorgesehen sind,
- bei der am Boden der Gräben (5) und an der Hauptfläche (2) zwischen benachbarten Gräben (5) streifenförmige dotierte Gebiete (8) angeordnet sind, die von einem zweiten, dem ersten entgegengesetzten Leitfähigkeitstyp dotiert sind,
- bei der an den Flanken der Gräben (5) das Gatedielektrikum (17) angeordnet ist,
- bei der Wortleitungen (15) vorgesehen sind, die quer zu den Gräben (5) verlaufen,
- bei der die vertikalen MOS-Transistoren jeweils aus zwei an dieselbe Flanke eines der Gräben (5) angrenzenden streifenförmige dotierte Gebiete (8), die dazwischen angeordnete Flanken des Grabens, das Gatedielektrikum (14) und eine der Wortleitungen (18) gebildet werden.

3. Speicherzellenanordnung nach Anspruch 2,
- bei der der Abstand zwischen benachbarten Gräben (5) gleich der Breite der Gräben (5) ist,
- bei der der Abstand zwischen benachbarten Wortleitungen (18) gleich der Breite der Wortleitungen (18) ist.

4. Verfahren zur Herstellung einer Speicherzellenanordnung,
- bei dem in einer Hauptfläche (2) eines Substrats (1), das mindestens im Bereich der Hauptfläche (2) von einem ersten Leitfähigkeitstyp dotiertes Halbleitermaterial umfaßt, streifenförmige Gräben (5) gebildet werden, die im wesentlichen parallel verlaufen,
- bei dem an den Flanken der Gräben (5) zur Hauptfläche (2) vertikale MOS-Transistoren gebildet werden, die als Speicherzellen wirken und die je nach eingespeicherter Information mindestens drei unterschiedliche Einsatzspannungswerte aufweisen,
- bei dem ein erster Einsatzspannungswert durch die Dicke des Gatedielektrikums (16) und ein zweiter und ein dritter Einsatzspannungswert durch unterschiedliche Kanaldotierungen realisiert werden.

5. Verfahren nach Anspruch 4,
- bei dem am Boden der Gräben (5) und an der Hauptfläche (2) zwischen benachbarten Gräben (5) streifenförmige dotierte Gebiete (8) gebildet werden, die von einem zweiten, zum ersten entgegengesetzten Leitfähigkeitstyp dotiert sind,
- bei dem eine isolierende Schicht (9) aufgebracht wird,
- bei dem auf der isolierende Schicht (9) eine erste Maske (10) erzeugt wird, die erste Öffnungen (11) aufweist,
- bei dem die isolierende Schicht (9) unter Verwendung der ersten Maske (10) durch anisotropes Ätzen so strukturiert wird, daß im Bereich der ersten Öffnungen (11) die Flanken von Gräben (5) mindestens teilweise freigelegt werden,
- bei dem die freigelegten Flanken dotiert werden,
- bei dem auf der isolierenden Schicht (9) eine zweite Maske (12) erzeugt wird, die zweite Öffnungen (13) aufweist,
- bei dem die isolierende Schicht (9) unter Verwendung der zweiten Maske (12) durch anisotropes Ätzen so strukturiert wird, daß auch im Bereich der zweiten Öffnungen (13) die Flanken von Gräben (5) mindestens teilweise freigelegt werden,
- bei dem an den Flanken der Gräben (5) ein Gatedielektrikum (17) gebildet wird,
- bei dem Wortleitungen (18) gebildet werden, die quer zu den Gräben verlaufen.

6. Verfahren nach Anspruch 5,
- bei dem die isolierende Schicht (9) die Gräben (5) auffüllt,
- bei dem die Flanken der Gräben (5) im Bereich der ersten und der zweiten Öffnungen (11, 13) im wesentlichen vollständig freigelegt werden.

7. Verfahren nach Anspruch 5 oder 6,
bei dem die Dotierung der Flanken durch gewinkelte Implantation erfolgt.

8. Verfahren nach Anspruch 7,
bei dem die Implantation mit einem Neigungswinkel im Bereich zwischen 20° und 30° und/oder - 20° und - 30° gegen die Normale der Hauptfläche (2) erfolgt.

9. Verfahren nach Anspruch 5 oder 6,
bei dem die Dotierung der Flanken durch Diffusion erfolgt.

10. Verfahren nach einem der Ansprüche 4 bis 9,
- bei dem nach der Bildung der Gräben (5) die Flanken der Gräben (5) mit Spacern (7) versehen werden,
- bei dem die streifenförmigen dotierten Gebiete (8) durch eine Implantation gebildet werden, bei der die Spacer (7) an den Flanken der Gräben (5) maskierend wirken,
- bei dem die Spacer (7) nach Bildung der streifenförmigen dotierten Gebiete (8) entfernt werden.

## Claims

1. Memory cell arrangement
- in which memory cells are provided in a substrate (1) which comprises, at least in the region of a main area (2), semiconductor material which is doped by a first conductivity type, which memory cells each comprise an MOS transistor which is vertical with respect to the main area (2),
- in which the vertical MOS transistors have at least three different threshold voltage values depending on the stored information,
- in which a first threshold voltage value is realised by the thickness of the gate dielectric (16) and a second and a third threshold voltage value are realised by different channel dopings.

2. Memory cell arrangement according to Claim 1,
- in which strip-like trenches (5) which essentially run in parallel are provided in the substrate (1),
- in which strip-like, doped regions (8), which are doped by a second conductivity type opposite to the first, are arranged on the bottom of the trenches (5) and on the main area (2) between adjacent trenches (5),
- in which the gate dielectric (17) is arranged on the sides of the trenches (5),
- in which word lines (15) are provided which run transversely with respect to the trenches (5),
- in which the vertical MOS transistors are in each case formed by two strip-like, doped regions (8) adjoining the same side of one of the trenches (5), the trench sides arranged in between, the gate dielectric (14) and one of the word lines (18).

3. Memory cell arrangement according to Claim 2,
- in which the spacing between adjacent trenches (5) is equal to the width of the trenches (5),
- in which the spacing between adjacent word lines (18) is equal to the width of the word lines (18).

4. Method for the production of a memory cell arrangement,
- in which strip-like trenches (5) which essentially run in parallel are formed in a main area (2) of a substrate (1) which comprises, at least in the region of the main area (2), semiconductor material which is doped by a first conductivity type,
- in which MOS transistors which are vertical with respect to the main area (2) are formed on the sides of the trenches (5), act as memory cells and have at least three different threshold voltage values depending on the stored information,
- in which a first threshold voltage value is realised by the thickness of the gate dielectric (16) and a second and a third threshold voltage value are realised by different channel dopings.

5. Method according to Claim 4,
- in which strip-like, doped regions (8), which are doped by a second conductivity type opposite to the first, are formed on the bottom of the trenches (5) and on the main area (2) between adjacent trenches (5),
- in which an insulating layer (9) is applied,
- in which a first mask (10) which has first openings (11) is produced on the insulating layer (9),
- in which the insulating layer (9) is structured by anisotropic etching, while using the first mask (10), in such a way that the sides of trenches (5) are at least partially exposed in the region of the first openings (11),
- in which the exposed sides are doped,
- in which a second mask (12) which has second openings (13) is produced on the insulating layer (9),
- in which the insulating layer (9) is structured by anisotropic etching, while using the second mask (12), in such a way that the sides of trenches (5) are at least partially exposed in the region of the second openings (13), as well,
- in which a gate dielectric (17) is formed on the sides of the trenches (5),
- in which word lines (18) are formed which run transversely with respect to the trenches.

6. Method according to Claim 5,
- in which the insulating layer (9) fills the trenches (5),
- in which the sides of the trenches (5) are essentially completely exposed in the region of the first and of the second openings (11, 13).

7. Method according to Claim 5 or 6,
in which the sides are doped by angled implantation.

8. Method according to Claim 7,
in which the implantation is carried out at an angle of inclination in the range between 20E and 30E and/or -20E and -30E with respect to the normal to the main area (2).

9. Method according to Claim 5 or 6,
in which the sides are doped by diffusion.

10. Method according to one of Claims 4 to 9,
- in which the trenches (5) are formed and then the sides of the trenches (5) are provided with spacers (7),
- in which the strip-like, doped regions (8) are formed by implantation in which the spacers (7) on the sides of the trenches (5) have a masking action,
- in which the spacers (7) are removed after the formation of the strip-like, doped regions (8).

## Revendications

1. Configuration de cellules de mémoire,
- dans laquelle on prévoit, dans un substrat (1) comprenant, au moins dans la région d'une surface principale (2), un matériau semi-conducteur dopé par un premier type de conduction, des cellules de mémoire qui comprennent à chaque fois un transistor MOS vertical par rapport à la surface principale (2),
- dans laquelle les transistors MOS verticaux présentent au moins trois valeurs de tension de seuil différentes en fonction de l'information mémorisée,
- dans laquelle une première valeur de tension de seuil est réalisée par l'épaisseur du diélectrique de grille (17) et une deuxième et une troisième valeurs de tension de seuil sont réalisées par des dopages différents du canal.

2. Configuration de cellules de mémoire selon la revendication 1,
- dans laquelle on prévoit, dans le substrat (1), des fosses (5) en forme de bande s'étendant de manière essentiellement parallèle,
- dans laquelle des zones dopées (8) en forme de bande sont situées au fond des fosses (5) et sur la surface principale (2) entre des fosses (5) voisines, lesquelles zones (8) sont dopées par un second type de conduction opposé au premier,
- dans laquelle le diélectrique de grille (17) est situé sur les flancs des fosses (5),
- dans laquelle on prévoit des lignes de mots (18) qui s'étendent perpendiculairement par rapport aux fosses (5),
- dans laquelle les transistors MOS verticaux sont formés à chaque fois par deux zones dopées (8) en forme de bande contiguës au même flanc d'une des fosses (5), les flancs de la fosse situés entre ces deux zones, le diélectrique de grille (17) et une des lignes de mots (18).

3. Configuration de cellules de mémoire selon la revendication 2,
- dans laquelle la distance entre des fosses (5) voisines est égale à la largeur des fosses (5),
- dans laquelle la distance entre des lignes de mots (18) voisines est égale à la largeur des lignes de mots (18).

4. Procédé de fabrication d'une configuration de cellules de mémoire,
- dans lequel on forme, dans une surface principale (2) d'un substrat (1) comprenant, au moins dans la région de la surface principale (2), un matériau semi-conducteur dopé par un premier type de conduction, des fosses (5) en forme de bande qui s'étendent de manière essentiellement parallèle,
- dans lequel on forme, sur les flancs des fosses (5), des transistors MOS verticaux par rapport à la surface principale (2), qui agissent en tant que cellules de mémoire et présentent, en fonction de l'information mémorisée, au moins trois valeurs de tension de seuil différentes,
- dans lequel une première valeur de tension de seuil est réalisée par l'épaisseur du diélectrique de grille (17) et une deuxième et une troisième valeurs de tension de seuil sont réalisées par des dopages différents du canal.

5. Procédé selon la revendication 4,
- dans lequel on forme, au fond des fosses (5) et sur la surface principale (2) entre les fosses (5) voisines, des zones dopées (8) en forme de bande qui sont dopées par un second type de conduction opposé au premier,
- dans lequel on applique une couche isolante (9),
- dans lequel on produit, sur la couche isolante (9), un premier masque (10) pourvu de premières ouvertures (11),
- dans lequel on structure la couche isolante (9) par attaque anisotrope en utilisant le premier masque (10), de manière à ce que les flancs des fosses (5) soient dégagés, au moins partiellement, dans la région des premières ouvertures (11),
- dans lequel les flancs dégagés sont dopés,
- dans lequel on produit, sur la couche isolante (9), un deuxième masque (12) pourvu de deuxièmes ouvertures (13),
- dans lequel on structure la couche isolante (9) par attaque anisotrope en utilisant le deuxième masque (12), de manière à ce que les flancs des fosses (5) soient dégagés, au moins partiellement, dans la région des deuxièmes ouvertures (13) également,
- dans lequel on forme un diélectrique de grille (17) sur les flancs des fosses (5),
- dans lequel on forme des lignes de mots (18) qui s'étendent perpendiculairement par rapport aux fosses.

6. Procédé selon la revendication 5,
- dans lequel la couche isolante (9) remplit les fosses (5),
- dans lequel les flancs des fosses (5) sont essentiellement complètement dégagés dans la région des premières et des deuxièmes ouvertures (11, 13).

7. Procédé selon l'une des revendications 5 ou 6,
dans lequel le dopage des flancs se fait par implantation angulaire.

8. Procédé selon la revendication 7,
dans lequel l'implantation se fait avec un angle d'inclinaison compris entre 20° et 30° et/ou -20° et -30° par rapport à la normale de la surface principale (2).

9. Procédé selon l'une des revendications 5 ou 6,
dans lequel le dopage des flancs se fait par diffusion.

10. Procédé selon l'une des revendications 4 à 9,
- dans lequel, après la formation des fosses (5), les flancs des fosses (5) sont pourvus de couches d'espacement (7),
- dans lequel les zones dopées (8) en forme de bande sont formées par une implantation lors de laquelle les couches d'espacement (7) sur les flancs des fosses (5) agissent comme un masque,
- dans lequel les couches d'espacement (7) sont éliminées après la formation des zones dopées (8) en forme de bande.
